# EUROPEAN PATENT SPECIFICATION

(11) **EP 2 384 107 B1**
(45) Date of publication and mention of the grant of the patent: **06.11.2013**
(21) Application number: 09836454.0
(22) Date of filing: 25.12.2009
(51) Int. Cl.: H05K 7/20

(54) **DEVICE FOR REMOVING HEAT FROM HEAT DISSIPATION SYSTEMS (EMBODIMENTS)**
VORRICHTUNG ZUM ABFÜHREN VON WÄRME AUS WÄRMEABLEITUNGSSYSTEMEN (AUSFÜHRUNGSFORMEN)
DISPOSITIF D'ÉVACUATION DE CHALEUR DE SYSTÈMES DE DISSIPATION THERMIQUE (MODES DE RÉALISATION)

(30) Priority: 29.12.2008 RU 2008151915
(43) Date of publication of application: 02.11.2011
(73) Proprietor: Burdin, Sergei Germanovich, 422986 Respublika Tatarstan (RU)
(72) Inventor: Burdin, Sergei Germanovich, 422986 Respublika Tatarstan (RU)
(74) Representative: Sloboshanin, Sergej
(86) International application number: PCT/RU2009/000723
(87) International publication number: WO 2010/077180

(56) References cited:
- DE-A1- 4 108 981
- GB-A- 2 103 782
- RU-C1- 2 255 437
- RU-C2- 2 301 510
- US-A- 3 481 393
- US-A- 5 903 432
- US-B1- 6 948 556

## Description

The invention relates to radio engineering and can be used in systems for cooling heat releasing units in radio electronic equipment.

The system for cooling radio electronic equipment is known that comprises heat-insulated evaporation chamber with heat-transfer agent and condensation chamber connected to each other by means of two heat-insulated pipes; the evaporation chamber is designed to be capable of heat removal from cooled radioelements and is mounted below the condensation chamber; one of the heat-insulated pipes is designed to be capable of vapour transporting from the evaporation chamber to the condensation chamber, the second one is designed to be capable of liquid transporting from the condensation chamber to the evaporation chamber. RU 2301510 C2, 20.06.2005 discloses a device having the features in the preamble of claim 1. DE-A1-4108981 and US 6948556-B1 also disclose devices relevant to the invention.

The disadvantage of this construction is eco-friendliness deficiency, no possibility to use energy from heat release.

Technical result of the offered invention is the possibility to use energy from heat release that gives the opportunity to increase the eco-friendliness and operating efficiency of the device.

It can be achieved owing to the fact that the device for heat removal comprises heat-insulated evaporation chamber with heat-transfer agent and condensation chamber connected to each other by means of two heat-insulated pipes; the evaporation chamber is designed to be capable of heat removal from heat releasing units and is mounted below the condensation chamber; one of the heat-insulated pipes is designed to be capable of liquid transporting from the evaporation chamber to the condensation chamber, the second one is designed to be capable of liquid transporting from the condensation chamber to the evaporation chamber; the device is characterized by the equipment with additional chamber mounted on the level between the evaporation chamber and the condensation chamber and connected to the second heat-insulated pipe with the help of a control valve, and with a hydraulic motor mounted on the first heat-insulated pipe in the way its input is connected with the evaporation chamber and its output is connected to the condensation chamber; the control valve is designed to be capable of coupling the additional chamber to the condensation chamber for periodical filling of the additional chamber with liquid transported from the condensation chamber; or to be capable of coupling the additional chamber to the evaporation chamber for later emptying of the additional chamber and liquid transporting to the evaporation chamber; heat-transfer agent consists of, at least, two immiscible and chemically no reactive liquid components, one of them is a refrigerant that changes its state of aggregation from liquid to gaseous while heating during heat removal from heat releasing systems ensuring pressure difference in the evaporation chamber and the condensation chamber, and the second component does not change its state of aggregation and is transferred from the evaporation chamber to the condensation chamber while heating during heat removal from heat releasing systems due to pressure difference in these chambers.

Besides as a refrigerant (heat-transfer agent) the refrigerant is used that gives pressure difference of saturated vapour of the refrigerant 100-900kPa in the evaporation chamber and the condensation chamber with temperature difference 10-60°C.

Besides, the refrigerant is chosen from the following series: saturated hydrocarbons, saturated halogen replaced hydrocarbons and their mixtures.

Besides, the refrigerant is chosen from the following series: butane, isobutane, propane, freons.

Besides the evaporation chamber is equipped with air or liquid radiator for heat extraction from heat releasing systems.

Besides the condensation chamber is equipped with air or liquid radiator for heat removal to outer sphere.

Besides, the device is equipped with a thermocompressor which evaporator is placed on the condensation chamber radiator and condenser is placed on the evaporation chamber radiator.

Besides, heat-insulating plate is freely mounted in the condensation chamber having positive buoyancy relatively to the heat-transfer agent component that does not change its state of aggregation, and negative one relatively to the refrigerant.

Besides, insert of porous material is mounted in the condensation chamber at the second heat-insulated pipe input to provide throttling and partial heat recovery to heat-transfer agent when transferring heat-transfer agent vapour from the additional chamber to the condensation chamber.

Besides, the hydraulic motor is designed to be capable to be connected to peripheral equipment for its rotation energy use.

The device is illustrated with drawings.

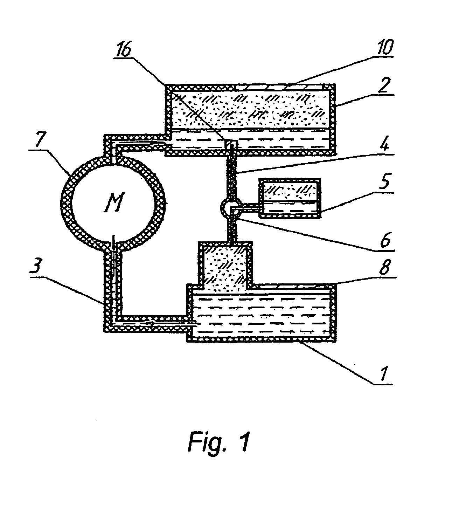

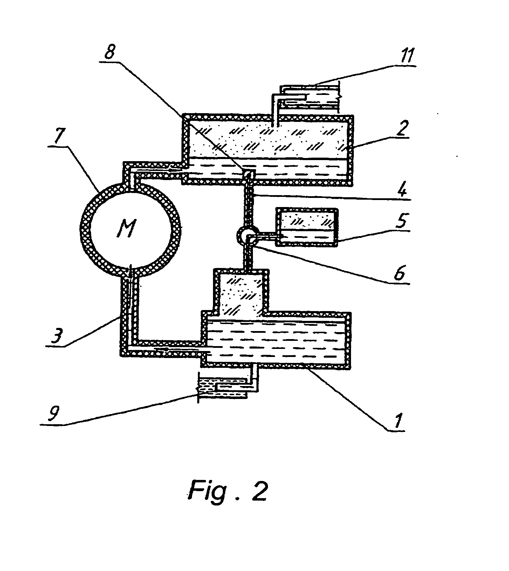

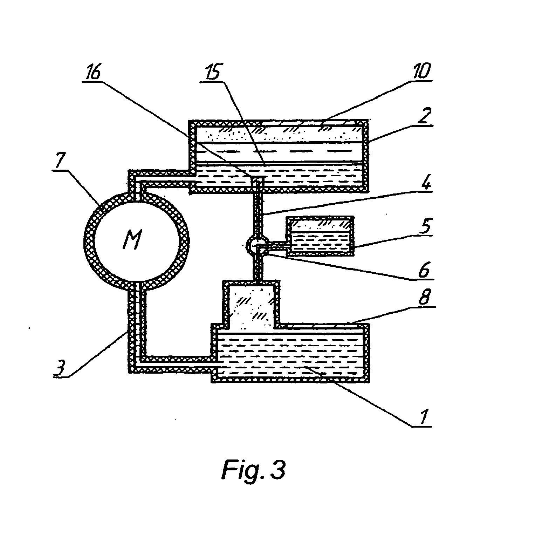

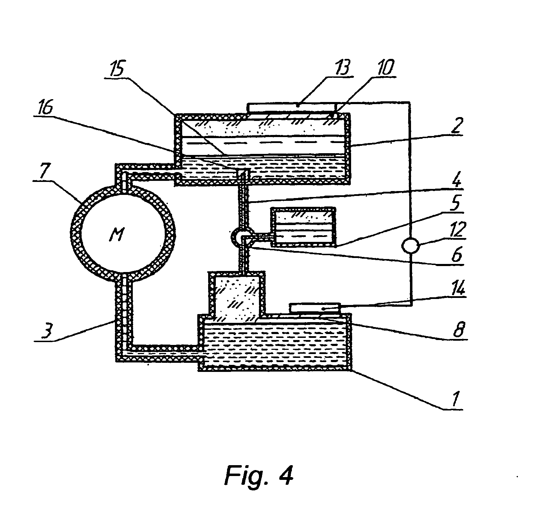

In fig.1 a device for heat removal with air radiators is shown; in fig.2 - the same device with liquid radiators; in fig.3 - the same device with heat-insulating plate; in fig.4 - the same device with thermocompressor.

The device for heat removal comprises heat-insulated evaporation chamber I and condensation chamber 2 with a heat-transfer agent and connected by means of two heat-insulated pipes 3 and 4. The evaporation chamber 1 is placed below the condensation chamber 2 and is designed to be capable of heat removal from heat releasing units. One of the heat-insulated pipes 3 is designed to be capable of liquid transporting from the evaporation chamber 1 to the condensation chamber 2, and the second pipe 4 is designed to be capable of liquid transporting from the condensation chamber 2 to the evaporation chamber 1.

The additional chamber 5 is mounted on the level between the evaporation chamber 1 and the condensation chamber 2 and connected to the second heat-insulated pipe 4 with the help of the control valve 6.

The hydraulic motor 7 is mounted on the first heat-insulated pipe 3. Its input is connected to the evaporation chamber 1 and its output is connected to the condensation chamber 2. The hydraulic motor is designed to be capable to be connected to peripheral equipment for its rotation energy use.

The control valve 6 is designed to be capable of coupling the additional chamber 5 to the condensation chamber 2 for periodical filling of the additional chamber 5 with liquid transported from the condensation chamber 2, or coupling the additional chamber 5 to the evaporation chamber I for later emptying of the additional chamber 5 and liquid transporting to the evaporation chamber 1.

The evaporation chamber 1 can be equipped with air radiator 8 or liquid radiator 9 for heat extraction from heat releasing systems.

The condensation chamber 2 can be equipped with air radiator 10 or liquid radiator 11 for heat removal to outer sphere.

The device can be equipped with thermocompressor 12 which evaporator 13 is placed on the radiator 10 of the condensation chamber 2, and condenser 14 is placed on the radiator 8 of the evaporation chamber 1. The thermocompressor 12 is used for partial heat recovery from the condensation chamber 2 to the evaporation chamber 1. It increases the coefficient of heat energy to mechanical energy conversion.

Heat-insulated plate 15 can be freely mounted in the condensation chamber 2, having positive buoyancy relatively to the second component of working liquid, it does not change its state of aggregation and is negative relatively to the refrigerant. It is used to decrease heat transfer from the second component to the refrigerant. The efficiency of heat energy to mechanical energy conversion increases.

Insert 16 of porous material is mounted in the condensation chamber 2 at the second heat-insulated pipe 4 input to provide throttling and partial heat recovery to working fluid when transferring heat-transfer agent vapour from the additional chamber 5 to the condensation chamber 2.

As working fluid, mixture consisting of, at least, two immiscible and chemically no reactive components is used, on of them is a refrigerant that changes its state of aggregation from liquid to gaseous while heating during heat removal from heat releasing systems and the other component does not change its state of aggregation when heating during heat removal from heat releasing systems. As a heat-transfer agent refrigerant is used that gives pressure difference of saturated vapour of the refrigerant 100-900kPa in the evaporation chamber and the condensation chamber with temperature difference 10-60.°C in these chambers.

The refrigerant is chosen from the following series: saturated hydrocarbons, saturated halogen replaced hydrocarbons and their mixtures.

The refrigerant is chosen from the following series: butane, isobutane, propane, freons.

The device works in the following way.

When temperature of heat releasing system increases owing to radio electronic equipment operation working fluid in the evaporation chamber 1 heats through the radiator (8 or 9). Working fluid consists of 2 components, for example. One of the components of working fluid is a refrigerant (for example, isobutane) and has low boiling and vaporization temperature -10°C when pressure is 100kPa.

As the other component, for example, water, aqueous-alcoholic solution is used. Isobutane evaporates, but water or aqueous-alcoholic solution does not evaporate.

In the evaporation chamber 1 a refrigerant evaporates when heating and owing to high temperature of the radiator pressure of saturated vapour of the refrigerant reaches high level over the range 260-900kPa, and in the condensation chamber 2 connected to the evaporation chamber 1 by means of heat-insulated pipe 3 lower temperature of the radiator results in low pressure over the range 100-740kPa accordingly. Due to pressure difference in these chambers the second liquid component (water, aqueous-alcoholic solution) is transferred. This component transfer results in kinetic energy of fluid that converts to rotation energy of hydraulic motor mounted in different parts of the device (in accordance with the first or the second variants).

Thus, heat conversion into mechanical energy of hydraulic motor rotation is obtained during heat removal.

Return is made through the additional chamber 5 mounted on the level between the evaporation chamber 1 and the condensation chamber 2. The control valve 6 makes it possible to connect periodically the additional chamber 5 to the condensation chamber 1 for periodical filling the additional chamber 5 with liquid transported from the condensation chamber 2; and to the evaporation chamber 1 for later emptying of additional chamber 5 and liquid transporting to the evaporation chamber 1. Thus, process cyclicity is obtained.

The disadvantage of this construction is eco-friendliness deficiency, no possibility to use energy from heat release.

The invention makes it possible to use energy from heat release that gives the opportunity to increase the eco-friendliness and operating efficiency of the device.

## Claims

1. The device for heat removal comprises heat-insulated evaporation chamber (1) with heat-transfer agent and condensation chamber (2) connected to each other by means of two heat-insulated pipes; the evaporation chamber (1) is designed to be capable of heat removal from heat releasing units and is mounted below the condensation chamber (2); one of the heat-insulated pipes (3) is designed to be capable of liquid transporting from the evaporation chamber to the condensation chamber, the second one (4) is designed to be capable of liquid transporting from the condensation chamber (2) to the evaporation chamber (1); the device is **characterized by** the equipment with additional chamber (5) mounted on the level between the evaporation chamber and the condensation chamber and connected to the second heat-insulated pipe with the help of a control valve (6), and with a hydraulic motor (7) mounted on the first heat-insulated pipe in the way its input is connected with the evaporation chamber and its output is connected to the condensation chamber; the control valve (6) is designed to be capable of coupling the additional chamber (5) to the condensation chamber (2) for periodical filling of the additional chamber with liquid transported from the condensation chamber; or to be capable of coupling the additional chamber to the evaporation chamber (2) for later emptying of the additional chamber (5) and liquid transporting to the evaporation chamber (1); heat-transfer agent consists of, at least, two immiscible and chemically no reactive liquid components, one of them is a refrigerant that changes its state of aggregation from liquid to gaseous while heating during heat removal from heat releasing systems ensuring pressure difference in the evaporation chamber (1) and the condensation chamber (2), and the second component does not change its state of aggregation and is transferred from the evaporation chamber (1) to the condensation chamber (2) while heating during heat removal from heat releasing systems due to pressure difference in these chambers.

2. The device according to claim 1 is **characterized by** the fact that as a heat-transfer agent refrigerant is used that gives pressure difference of saturated vapour of the refrigerant 100-900kPa in the evaporation chamber (1) and the condensation chamber (2) with temperature difference 10-60°C.

3. The device according to claims 1 or 2 is **characterized by** the fact that the refrigerant is chosen from the following series: saturated hydrocarbons, saturated halogen replaced hydrocarbons and their mixtures.

4. The device according to claim 3 is **characterized by** the fact that the refrigerant is chosen from the following series: butane, isobutane, propane, freons.

5. The device according to claim 1 is **characterized by** the fact that the evaporation chamber (1) is equipped with air or liquid radiator for heat extraction from heat releasing systems.

6. The device according to claims 1 or 5 is **characterized by** the fact that the condensation chamber (2) is equipped with air or liquid radiator for heat removal to outer sphere.

7. The device according to claim 6 is **characterized by** the fact that it is equipped with a thermocompressor which evaporator (13) is placed on the condensation chamber radiator and condenser (14) is placed on the evaporation chamber radiator.

8. The device according to claim 1 is **characterized by** the fact that heat-insulating plate (15) is freely mounted in the condensation chamber having positive buoyancy relatively to the heat-transfer agent component that does not change its state of aggregation, and negative one relatively to the refrigerant.

9. The device according to claim 1 is **characterized by** the fact that insert of porous material (16) is mounted in the condensation chamber (2) at the second heat-insulated (4) pipe input to provide throttling and partial heat recovery to heat-transfer agent when transferring heat-transfer agent vapour from the additional chamber (5) to the condensation chamber.

10. The device according to claim 1 is **characterized by** the fact that the hydraulic motor (7) is designed to be capable to be connected to peripheral equipment for its rotation energy use.

## Patentansprüche

1. Vorrichtung zur Wärmeabfuhr umfassend eine wärmeisolierte Verdampfungskammer (1) mit einem Wärmeübertragungsmittel und eine Kondensationskammer (2), die mittels zweier wärmeisolierter Rohre miteinander verbunden sind, wobei die Verdampfungskammer (1) so ausgelegt ist, dass sie eine Wärmeabfuhr von Wärmefreigabeeinheiten bereitstellen kann, und unter der Kondensationskammer (2) angebracht ist, wobei eines der wärmeisolierten Rohre (3) so ausgelegt ist, dass es den Transport einer Flüssigkeit von der Verdampfungskammer zu der Kondensationskammer bereitstellen kann, wobei das zweite (4) so ausgelegt ist, dass es den Transport einer Flüssigkeit von der Kondensationskammer (2) zu der Verdampfungskammer (1) bereitstellen kann, wobei die Vorrichtung **dadurch gekennzeichnet ist, dass** sie mit einer zusätzlichen Kammer (5), die auf dem Niveau zwischen der Verdampfungskammer und der Kondensationskammer angebracht und mit Hilfe eines Steuerventils (6) mit dem zweiten wärmeisolierten Rohr verbunden ist, und mit einem Hydraulikmotor (7) ausgerüstet ist, der an dem ersten wärmeisolierten Rohr derart angebracht ist, dass sein Eingang mit der Verdampfungskammer verbunden ist und sein Ausgang mit der Kondensationskammer verbunden ist, wobei das Steuerventil (6) so ausgelegt ist, dass es für eine periodische Füllung der zusätzlichen Kammer mit einer von der Kondensationskammer transportierten Flüssigkeit eine Kopplung der zusätzlichen Kammer (5) mit der Kondensationskammer (2) bereitstellen kann, oder dass es für eine spätere Leerung der zusätzlichen Kammer (5) und den Transport der Flüssigkeit zu der Verdampfungskammer (1) eine Kopplung der zusätzlichen Kammer mit der Verdampfungskammer (2) bereitstellen kann, wobei das Wärmeübertragungsmittel aus wenigstens zwei unvermischbaren und chemisch nicht reagierenden flüssigen Komponenten besteht, von denen eine ein Kältemittel ist, das seinen Aggregatszustand von flüssig zu gasförmig ändert, während es sich bei der Wärmeabfuhr von den Wärmefreigabesystemen erwärmt, was einen Druckunterschied in der Verdampfungskammer (1) und der Kondensationskammer (2) sicherstellt, und wobei die zweite Komponente ihren Aggregatszustand nicht ändert und von der Verdampfungskammer (1) zu der Kondensationskammer (2) übertragen wird, während sie sich bei der Wärmeabfuhr von den Wärmefreigabesystemen aufgrund des Druckunterschieds in diesen Kammern erwärmt.

2. Vorrichtung nach Anspruch 1, **dadurch gekennzeichnet, dass** als Wärmeübertragungsmittel ein Kältemittel verwendet wird, das einen Druckunterschied von gesättigtem Dampf des Kältemittels von 100-900 kPa in der Verdampfungskammer (1) und der Kondensationskammer (2) bei einem Temperaturunterschied von 10-60°C ergibt.

3. Vorrichtung nach Anspruch 1 oder 2, **dadurch gekennzeichnet, dass** das Kältemittel aus der folgenden Reihe ausgewählt ist: gesättigte Kohlenwasserstoffe, gesättigte durch Halogen ersetzte Kohlenwasserstoffe und ihre Gemische.

4. Vorrichtung nach Anspruch 3, **dadurch gekennzeichnet, dass** das Kältemittel aus der folgenden Reihe ausgewählt ist: Butan, Isobutan, Propan, Freone.

5. Vorrichtung nach Anspruch 1, **dadurch gekennzeichnet, dass** die Verdampfungskammer (1) mit einem Luft- oder Flüssigkeitsradiator für den Wärmeentzug aus Wärmefreigabesystemen ausgerüstet ist.

6. Vorrichtung nach den Ansprüchen 1 oder 5, **dadurch gekennzeichnet, dass** die Kondensationskammer (2) mit einem Luft- oder Flüssigkeitsradiator für die Wärmeabfuhr an die Außensphäre ausgerüstet ist.

7. Vorrichtung nach Anspruch 6, **dadurch gekennzeichnet, dass** sie mit einem Thermokompressor ausgerüstet ist, bei dem ein Verdampfer (13) auf dem Radiator der Kondensationskammer platziert ist und ein Kondensator (14) auf dem Radiator der Verdampfungskammer platziert ist.

8. Vorrichtung nach Anspruch 1, **dadurch gekennzeichnet, dass** eine wärmeisolierende Platte (15) in der Kondensationskammer frei angebracht ist, die relativ zu der Wärmeübertragungsmittelkomponente, die ihren Aggregatszustand nicht ändert, einen positiven Auftrieb und relativ zu dem Kältemittel einen negativen aufweist.

9. Vorrichtung nach Anspruch 1, **dadurch gekennzeichnet, dass** in der Kondensationskammer (2) am Eingang des zweiten wärmeisolierten Rohrs (4) ein Einsatz aus porösem Material (16) angebracht ist, um eine Drosselung und teilweise Wärmerückgewinnung zu dem Wärmeübertragungsmittel bereitzustellen, wenn Wärmeübertragungsmitteldampf von der zusätzlichen Kammer (5) zu der Kondensationskammer übertragen wird.

10. Vorrichtung nach Anspruch 1, **dadurch gekennzeichnet, dass** der Hydraulikmotor (7) so ausgelegt ist, dass er zur Nutzung seiner Rotationsenergie an Peripheriegeräte angeschlossen werden kann.

## Revendications

1. Dispositif d'évacuation de chaleur comprenant une chambre (1) d'évaporation thermiquement isolée avec un agent de transfert de chaleur et une chambre (2) de condensation connectées l'une à l'autre au moyen de deux tuyaux thermiquement isolés ; la chambre (1) d'évaporation est conçue pour être apte à une évacuation de chaleur hors d'unités dégageant de la chaleur et est montée en-dessous de la chambre (2) de condensation ; l'un (3) des tuyaux thermiquement isolés est conçu pour être apte à un transport de liquide de la chambre d'évaporation à la chambre de condensation, le deuxième (4) est conçu pour être apte à un transport de liquide de la chambre (2) de condensation à la chambre (1) d'évaporation ; le dispositif est **caractérisé par** l'équipement avec une chambre (5) additionnelle montée sur le niveau entre la chambre d'évaporation et la chambre de condensation et connectée au deuxième tuyau thermiquement isolé à l'aide d'une vanne (6) de commande, et avec un moteur (7) hydraulique monté sur le premier tuyau thermiquement isolé de telle manière que son entrée est connectée avec la chambre d'évaporation et sa sortie est connectée avec la chambre de condensation ; la vanne (6) de commande est conçue pour être apte à un couplage de la chambre (5) additionnelle à la chambre (2) de condensation pour un remplissage périodique de la chambre additionnelle avec un liquide transporté à partir de la chambre de condensation ; ou pour être apte à un couplage de la chambre additionnelle à la chambre (2) d'évaporation pour un vidage ultérieur de la chambre (5) additionnelle et un transport de liquide jusqu'à la chambre (1) d'évaporation ; l'agent de transfert de chaleur consiste en, au moins, deux composants liquides non miscibles et chimiquement non réactifs, l'un d'entre eux est un réfrigérant qui change son état d'agrégation de liquide à gazeux tout en chauffant lors de l'évacuation de chaleur de systèmes dégageant de la chaleur, assurant une différence de pression dans la chambre (1) d'évaporation et la chambre (2) de condensation, et le deuxième composant ne change pas son état d'agrégation et est transféré de la chambre (1) d'évaporation jusqu'à la chambre (2) de condensation tout en chauffant lors de l'évacuation de chaleur de systèmes dégageant de la chaleur du fait de la différence de pression dans ces chambres.

2. Dispositif selon la revendication 1, **caractérisé par le fait que**, comme un agent de transfert de chaleur, un réfrigérant est utilisé, qui donne une différence de pression de vapeur saturée du réfrigérant de 100 à 900 kPa dans la chambre (1) d'évaporation et la chambre (2) de condensation avec une différence de température de 10 à 60°C.

3. Dispositif selon la revendication 1 ou 2, **caractérisé par le fait que** le réfrigérant est choisi parmi la série suivante : hydrocarbures saturés, hydrocarbures saturés substitués avec un halogène et leurs mélanges.

4. Dispositif selon la revendication 3, **caractérisé par le fait que** le réfrigérant est choisi parmi la série suivante : butane, isobutane, propane, fréons.

5. Dispositif selon la revendication 1, **caractérisé par le fait que** la chambre (1) d'évaporation est équipée avec un radiateur à air ou liquide pour une extraction de chaleur de systèmes dégageant de la chaleur.

6. Dispositif selon la revendication 1 ou 5, **caractérisé par le fait que** la chambre (2) de condensation est équipée avec un radiateur à air ou liquide pour une évacuation de chaleur dans la sphère extérieure.

7. Dispositif selon la revendication 6, **caractérisé par le fait qu'**il est équipé avec un thermocompresseur dont l'évaporateur (13) est placé sur le radiateur de chambre de condensation et le condenseur (14) est placé sur le radiateur de chambre d'évaporation.

8. Dispositif selon la revendication 1, **caractérisé par le fait qu'**une plaque (15) d'isolation thermique est librement montée dans la chambre de condensation, ayant une flottabilité positive par rapport au composant d'agent de transfert de chaleur qui ne change pas son état d'agrégation, et une flottabilité négative par rapport au réfrigérant.

9. Dispositif selon la revendication 1, **caractérisé par le fait qu'**un insert de matériau poreux (16) est monté dans la chambre (2) de condensation au niveau de l'entrée du deuxième tuyau (4) thermiquement isolé pour provoquer un étranglement et une récupération partielle de chaleur pour l'agent de transfert de chaleur lors du transfert d'une vapeur d'agent de transfert de chaleur de la chambre (5) additionnelle jusqu'à la chambre de condensation.

10. Dispositif selon la revendication 1, **caractérisé par le fait que** le moteur (7) hydraulique est conçu pour être apte à être connecté à un équipement périphérique pour une utilisation de son énergie de rotation.
